**Europäisches Patentamt**

(19) **European Patent Office**

**Office européen des brevets**

(11) Veröffentlichungsnummer: **0 033 473**
**B1**

(12) **EUROPÄISCHE PATENTSCHRIFT**

(45) Veröffentlichungstag der Patentschrift:
**15.02.84**

(51) Int. Cl.³: **H 03 B 5/12**

(21) Anmeldenummer: **81100399.5**

(22) Anmeldetag: **20.01.81**

(54) **Stromgesteuerter Oszillator.**

(30) Priorität: **30.01.80 DE 3003302**

(43) Veröffentlichungstag der Anmeldung:
**12.08.81 Patentblatt 81/32**

(45) Bekanntmachung des Hinweises auf die Patenterteilung:
**15.02.84 Patentblatt 84/7**

(84) Benannte Vertragsstaaten:
**AT BE CH DE FR GB IT LI NL SE**

(56) Entgegenhaltungen:
**DE - A - 2 048 369**
**DE - A - 2 303 349**
**DE - B - 2 803 400**
**DE - C - 977 690**
**US - A - 4 071 832**

**ELECTRONICS LETTERS, Jahrgang 12, Nr. 23, 11.
November 1976, Seiten 614,615 London, G.B.
BHATTACHARYYA et al.: "Sinusoidal current-controlled
oscillator"**
**IEEE INTERNATIONAL SOLID STATE CIRCUITS
CONFERENCE, Jahrgang 22, Februar 1979, Seiten
234-235 New York, U.S.A. R.R. CORDELL et al.: "A
50MHz phase and frequency-locked loop"**

(73) Patentinhaber: **SIEMENS AKTIENGESELLSCHAFT,
Berlin und München Wittelsbacherplatz 2,
D-8000 München 2 (DE)**

(72) Erfinder: **Drügh, Paul, Dipl.-Phys., Stockmannstrasse 28,
D-8000 München 71 (DE)**
Erfinder: **von Winnicki, Kalixt, Ing. grad.,
Ortenburgstrasse 6, D-8000 München 71 (DE)**

## Stromgesteuerter Oszillator

Die Erfindung betrifft einen stromgesteuerten Oszillator mit einem Differenzverstärker, der zwei emittergekoppelte Transistoren enthält, deren Emitter an eine steuerbare Stromquelle angeschaltet sind, und mit einem Parallel-Schwingkreis, der zwischen dem Kollektor des ersten Transistors und dem Versorgungspotential angeschaltet ist und auf mindestens einen Eingang des Differenzverstärkers rückgekoppelt ist.

Für Steuer- und Regelzwecke werden hauptsächlich spannungsgesteuerte Oszillatoren (VCO) verwendet. Bei den weitaus meisten wird über Kapazitätsdioden die Oszillatorfrequenz geändert.

Aus der DE-PS 28 03 400 ist eine Oszillatorschaltung bekannt, die über eine Stromverteilungsschaltung eine zusäzliche Kapazität zur Schwingkreiskapazität hinzuschaltet. Auch in dieser Schaltung wird eine Reaktanz verändert.

In dem Aufsatz «Integrated Circuit Phase-Locked Loops» von R. R. Cordell aus dem Conf. Record, 1976, Intern. Conf. on Communications, 12th IEEE Intern. Conf., Philadelphia, 14-16 June, 1976, Seiten 10-12 bis 10-16 sind auf den Seiten 10-13 bis 10-15 stromgesteuerte Oszillatoren (CCO) beschrieben.

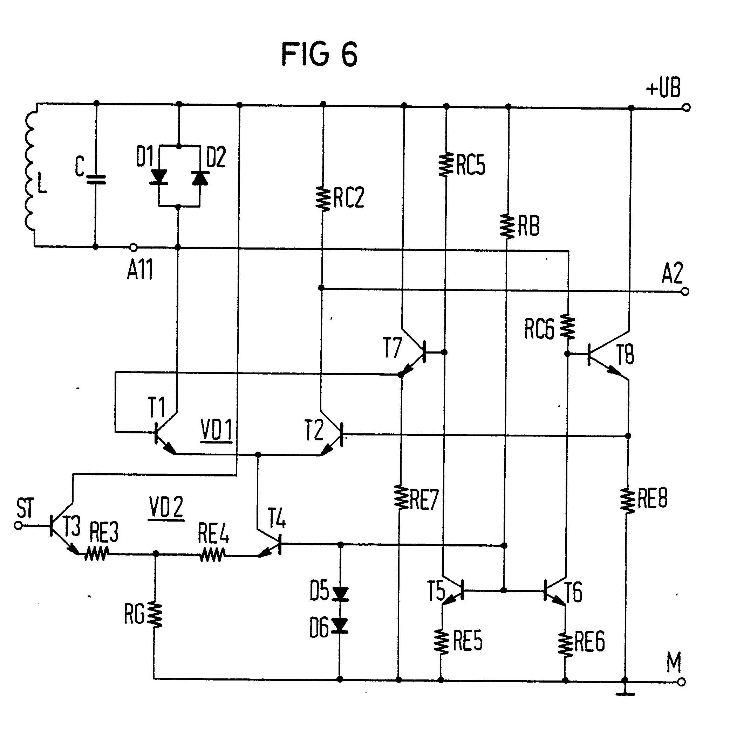

Fig. 6 des obigen Aufsatzes zeigt einen Multivibrator, dessen Frequenz über Emitterströme gesteuert wird. Hierdurch wird eine frequenzbestimmende Kapazität unterschiedlich schnell umgeladen. Diese Schaltung weist jedoch die bei Multivibratoren an sich bekannten Nachteile, wie unsauberes Frequenzspektrum und schlechte Frequenzstabilität auf. Eine praktisch verwendbare Oszillatorschaltung benötigt ausserdem einen beträchtlichen Schaltungsaufwand.

In der US-PS 40 71 832 ist ein stromgesteuerter Oszillator der eingangs genannten Art beschrieben. Bei jeder herkömmlichen Oszillatorschaltung findet eine Begrenzung der Signalamplitude statt. Hierdurch ist eine Frequenzverschiebung bedingt. Der beschriebene Oszillator nutzt diesen Effekt zur Frequenzänderung aus. Der Verstärker besteht aus zwei emittergekoppelten Transistoren, die von einer Stromquelle gespeist werden. Die Basis eines Transistors ist jeweils an den Kollektor des anderen Transistors angeschaltet. Ein Parallel-Schwingkreis ist wechselspannungsmässig zwischen den Kollektoren angeordnet.

Die Transistoren werden bei dieser Schaltung hauptsächlich im gesättigten Zustand betrieben, in dem sie für die Begrenzung der Spannung am Schwingkreis sorgen. Die Kollektor-Basis-Strecken der beiden Transistoren des Verstärkers liegen hierbei antiparallel zum Schwingkreis. Der Schwingkreisstrom kann in dieser Schaltungsanordnung nur maximal den Wert erreichen, der von der Urstromquelle geliefert wird. Durch den Sättigungszustand der Transistoren erreicht der Oszillator jedoch keine für höhere Anforderungen ausreichende Genauigkeit. Ein angeschalteter Verbraucher wirkt ausserdem direkt auf den Schwingkreis ein.

In der DE-OS 2 303 349 ist ein spannungsgesteuerter Oszillator mit einem LC-Serienschwingkreis beschrieben. Dieser Oszillator ist mit mehreren Differenzverstärkern aufgebaut. An den Reaktanzen des Schwingkreises werden phasenverschobene Spannungen abgegriffen, die in einer Mischschaltung addiert und subtrahiert werden. Die Grösse der resultierenden Spannungen ist steuerbar.

Die Ausgangssignale der Mischschaltung werden in einer Additionsschaltung vereinigt und einem Verstärker zugeführt, der den Resonanzkreis ansteuert.

Durch Steuerung der Addition und der Subtraktion wird eine Phasenänderung am Ausgang der Additionsschaltung erzielt, die zu einer Frequenzänderung des Oszillators führt.

Aufgabe der Erfindung ist es, einen steuerbaren Oszillator mit einfacher Schaltung anzugeben.

Ausgehend von einem einleitend beschriebenen Oszillator, wird die Aufgabe dadurch gelöst, dass zu dem Parallel-Schwingkreis ein spannungsbegrenzendes zusätzliches Bauelement parallelgeschaltet ist, dass der Kollektor des zweiten Transistors über einen Widerstand an das Versorgungspotential angeschlossen ist, dass der Kollektor des zweiten Transistors den Ausgang der Oszillatorschaltung bildet und dass als steuerbare Urstromquelle ein zweiter Differenzverstärker vorgesehen ist.

Der Erfindung liegt die Erkenntnis zugrunde, dass die Frequenz eines Oszillators geändert werden kann, indem die Spannung am Parallelschwingkreis begrenzt wird. Durch die Steuerung des Einsatzpunktes der Spannungsbegrenzung wird auch die Oszillatorfrequenz geändert. Die Steuerung der Spannungsbegrenzung und damit die Steuerung der Oszillatorfrequenz erfolgt zweckmässigerweise durch Änderung des Ausgangsstromes des Verstärkers der Oszillatorschaltung.

Ein Vorteil dieser Schaltung ist es, dass keinerlei steuerbare Reaktanzen benötigt werden. Die Herstellung des erfindingsgemässen LC-Oszillators ist entsprechend preisgünstig. Die Schaltung eignet sich ebenfals für monolithische Teil-Integration, bei der der Schwingkreis nicht integriert wird.

Bei dieser Oszillatorschaltung wird der Schwingkreis hochohmig angesteuert, seine Resonanzeigenschaften bewirken hohe Frequenzstabilität. Durch den als Urstromquelle des ersten Differenzverstärkers verwendeten zweiten Differenzverstärker wird die Oszillatorfrequenz von einer Steuerspannung kontrolliert, die direkt den frequenzbetimmenden Urstrom steuert. Der Ausgang des Oszillator ist über den zweiten Transistor entkoppelt.

Der stromgesteuerte Oszillator ist anstelle von spannungsgesteuerten Oszillatoren einsetzbar.

Es ist vorteilhaft, dass der zweite Differenzverstärker zwei emittergekoppelte Transistoren enthält, dass der Kollektor des einen Transistors, dessen Basis an einem festen Spannungspotential liegt, mit den Emittern der beiden Transistoren des Differenzverstärkers verbunden ist, dass der Kollektor des anderen Transistors des weiteren Differenzverstärkers mit dem Versorgungspotential verbunden ist, dass an der Basis des anderen Transistors eine frequenzbestimmende Steuerspannung anliegt und dass der beiden Emittern der Transistoren des zweiten Differenzverstärkers gemeinsame ohmsche Emitterwiderstand an Masse (das zweite Versorgungspotential) geschaltet ist.

Durch die Verwendung eines zweiten Differenzverstärkers erhält man eine Urstromquelle hoher Konstanz.

Zur Erzielung einer hohen Stabilität ist es vorteilhaft, dass eine steuerbare Stromquelle mit dem gleichen relativen Temperaturverhalten wie das parallel zum Schwingkreis geschaltete spannungsbegrenzende Bauelement vorgesehen ist.

Bildet man die steuerbare Urstromquelle so aus, dass sie den gleichen Temperaturgang hat wie das spannungsbegrenzende Element, das parallel zum Schwingkreis liegt, so wird der Oszillator temperaturunabhängig.

Weitere vorteilhafte Weiterbildungen der Erfindung sind in den übrigen Unteransprüchen angegeben.

Die Erfindung wird im folgenden anhand der Figuren 1 bis 7 näher erläutert.

Fig. 1 ein Prinzipschaltbild eines stromgesteuerten Oszillators,

Fig. 2 eine erstes Ausführungsbeispiel eines erfindungsgemässen Oszillators,

Fig. 3 das Prinzipschaltbild des Oszillators nach Fig. 2,

Fig. 4 das Zeitdiagramm zu dem Prinzipschaltbild nach Fig. 2, das den Spannungs- und Stromverlauf der Oszillatorschaltung zeigt,

Fig. 5 den normierten Frequenzverlauf des Oszillators als Funktion des Steuerstromes,

Fig. 6 das Schaltbild eines für monolithische Teilintegration geeigneten LC-Oszillators.

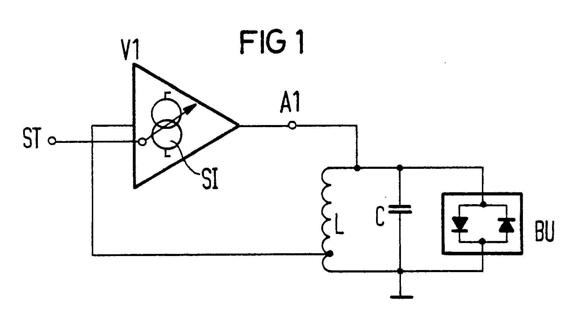

Fig. 1 zeigt das Prinzipschaltbild eines stromgesteuerten Oszillators. An den Ausgang A1 eines Verstärkers V1 ist ein Parallel-Schwingkreis L, C angeschlossen. Über eine Anzapfung der Spule L ist der Parallel-Schwingkreis auf den Eingang des Verstärkers V1 zurückgekoppelt. Parallel zum Parallel-Schwingkreis L, C ist ein spannungsbegrenzendes Bauelement BU geschaltet. Antiparallele Dioden, Z-Dioden oder Transistoren eignen sich zur Spannungsbegrenzung. Der Ausgangstrom des Verstärkers wird über einen Steuereingang ST durch eine steuerbare Stromquelle SI bestimmt.

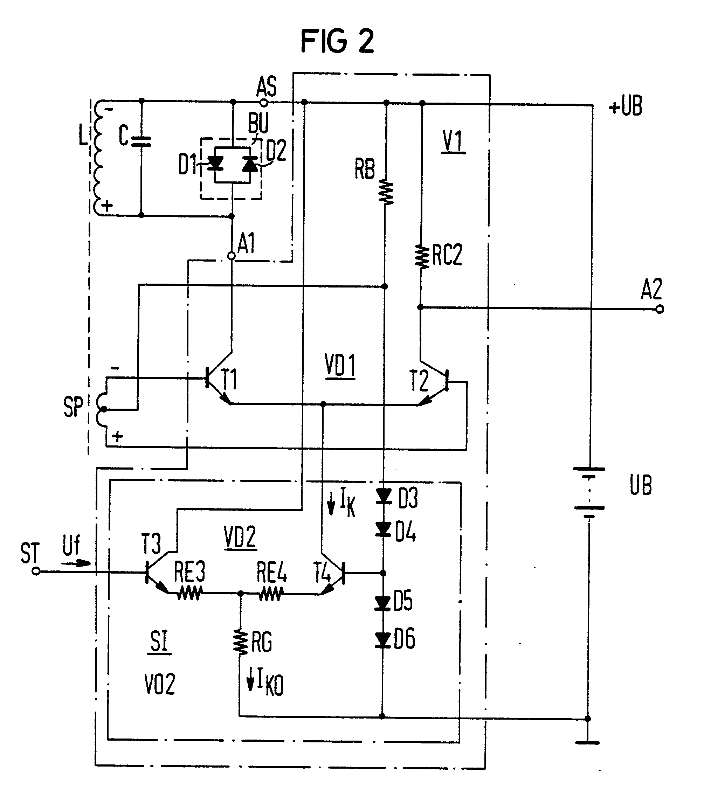

In Fig. 2 ist ein Ausführungsbeispiel eines stromgesteuerten Oszillators dargestellt. In der Oszillatorschaltung wird ein emittergekoppelter Differenzverstärker VD1 mit zwei npn-Transistoren T1 und T2 verwendet. An den Kollektor des ersten Transistors T1, Anschlusspunkt A1, ist der aus der Induktivität L und der Kapazität C bestehende Parallel-Schwingkreis angeschlossen. Der zweite Anschlusspunkt AS des Parallel-Schwingkreises ist an das Versorgungspontential +UB der Batterie UB gelegt. Parallel zum Schwingkreis ist die Spannungsbegrenzerschaltung BU geschaltet. Sie besteht aus zwei antiparallel geschalteten Dioden D1 und D2. Mit der Induktivität L des Parallel-Schwingkreises ist eine Spule SP gekoppelt. Je ein Anschluss der Spule SP ist auf die Basis des Transistors T1 und auf die Basis des Transistors T2 geführt. Die Basisvorspannung für die Transistoren T1 und T2 wird von der Reihenschaltung eines ohmschen Widerstandes RB und vier hintereinander in Durchlassrichtung geschalteten Dioden D3 bis D6 erzeugt, wobei ein Anschluss des Widerstandes RB an das Versorgungspotential +UB und die letzte Diode D6 an Masse geschaltet ist. Der zweite mit der Diode D3 verbundene Anschlusspunkt des Widerstandes RB liefert über eine Mittelanzapfung der Spule SP die Basisvorspannung für die Transistoren T1 und T2.

Der Kollektor des zweiten Transistors T2 ist über einen ohmschen Widerstand RC2 an das Versorgungspotential +UB angeschlossen. Ausserdem ist der Kollektor dieses zweiten Transistors T2 auf einen Anschlusspunkt A2, den Ausgang der Oszillatorschaltung, geführt.

Als steuerbare Stromquelle SI wird ein zweiter Differenzverstärker VD2 mit zwei emittergekoppelten npn-Transistoren T3 und T4 verwendet. Die Emitter sind nicht direkt miteinander verbunden, sondern jeweils über einen Symmetrierwiderstand RE3 bzw. RE4 zusammengeschaltet und auf einen gemeinsamen Emitterwiderstand RG geführt, dessen zweiter Anschluss an Masse gelegt ist. Der Kollektor des TransistorsT4 ist mit beiden Emittern des ersten Differenzverstärkers VD1 verbunden. Die Basis dieses Transistors T4 ist an den Verbindungspunkt der Dioden D4 und D5 geschaltet, so dass an ihr stets eine konstante Spannung liegt. Der Kollektor des Transistors T3 ist direkt mit dem Versorgungspotential +UB verbunden. Die Basis des Transistors T3 ist auf einen Steuereingang ST herausgeführt. Als Stromversorgung für die gesamte Oszillatorschaltung dient die Batterie UB, die das Versorgungspotential +UB liefert. Der zweite Anschluss der Batterie ist an Masse geschaltet.

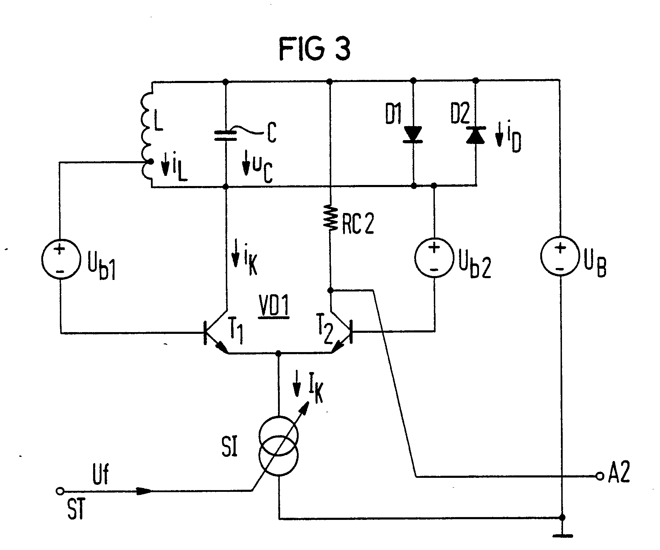

Da sich dieses Schaltbild nur schwer zur Erklärung des Oszillators verwenden lässt, ist das Prinzipschaltbild des Oszillators nach Fig. 2 in Fig. 3 dargestellt. Die Darstellung des ersten Differenzverstärkers VD1 mit seinen emittergekoppelten Transistoren T1 und T2 wurde beibehalten. Ebenso die Darstellung des an den Kollektor des ersten Transistors T1 angeschlossene Parallel-Schwingkreises mit der Induktivität L, der Kapazität C und der hierzu parallelgeschalteten Diode D1, sowie der hierzu antiparallelgeschalteten Diode D2. Der Kollektor des Transistors T1 ist über eine Spannungsquelle Ub2 auf die Basis des Transistors T2 zurückgekoppelt, die Basis des Transistors T1 ist über eine Spannungsquelle Ub1 an eine Anzapfung der Induktivität L geführt. Die Spannungsquellen Ub1 und Ub2 erzeugen die Basisvorspannungen für die Transistoren. Der Kollektor des TransistorsT2 ist über einen Widerstand RC2 an das Versorgungspotential +UB angeschlossen und ist ausserdem auf die Ausgangsklemme A2 geführt.

Die steuerbare Stromquelle SI mit dem Steuereingang ST ist nur symbolisch dargestellt. Sie ist einmal an die Emitter der Transistoren T1 und T2 des ersten Differenzverstärkers VD1 und mit einem zweiten Anschlusspunkt an Masse angeschlossen. Versorgt wird die Oszillator-Schaltung wieder von einer Batteriespannung $U_B$.

Durch die Stromquelle SI fliesst der Strom $I_K$, dessen Grösse von der am Anschlusspunkt ST anliegenden Steuerspannung Uf abhängig ist. Bei allen Darstellungen wird die rechnerische Stromrichtung vom positiven zum negativen Potential angegeben. Der durch die Induktivität L fliessende Strom ist mit $i_L$ bezeichnet, die am Schwingkreis herrschende Spannung ist mit $u_C$ bezeichnet, der durch den Transistor T1 fliessende Strom mit $i_K$ bezeichnet.

Fig. 2 stellt eine Oszillatorschaltung dar, bei der die Schwingkreisfrequenz auf die Eingänge des Differenzverstärkers zurückgekoppelt ist. Solange keinerlei Begrenzung auftritt, wird dieser Oszillator mit der Frequenz $f_0 = 1/2 \pi \sqrt{LC}$ schwingen.

Tritt jedoch eine Begrenzung der Schwingkreisspannung durch die Dioden D1 und D2 auf, so verringert sich die Frequenz des Oszillators. Der Einsatz der Spannungsbegrenzung bei einer vorgegebenen Begrenzerspannung wird durch die Schwingkreisspannung $u_C$ bestimmt. Diese ist wiederum von dem durch den Transistor T1 fliessenden Strom $i_K$ und somit vom durch die steuerbare Stromquelle SI fliessenden Urstrom $I_K$ abhängig.

Die Oszillatorschaltung ist so dimensioniert, dass entweder der Transistor T1 oder der Transistor T2 voll durchgeschaltet ist. Dies bedeutet, dass der Urstrom $I_K$ durch den Transistor T1 oder durch den Transistor T2 fliesst.

Zur Funktion der steuerbaren Urstromquelle SI wird nochmals auf Fig. 2 verwiesen. Die steuerbare Urstromquelle wird durch den Differenzverstärker VD2 gebildet. Über den Steuereingang ST liegt eine Steuerspannung Uf an der Basis des einen Transistors T3 dieses Differenzverstärkers VD2 an. Es wird angenommen, dass der Transistor T3 durch die Steuerspannung Uf gesperrt ist. Der gesamte Strom $I_K$ fliesst dann über den Transistor T4 und die Widerstände RE4 und RG. Die an der Basis des Transistors T4 liegende konstante Spannung, die am Verbindungspunkt der Dioden D4 und D5 abgegriffen wird, und die Emitterwiderstände RG + RE4 bestimmen die Grösse des Urstromes $I_{KO}$ des Differenzverstärkers VD2.

Ändert sich jetzt die Steuerspannung Uf an der Basis des Transistors T3, so wird ein Teil des durch den Widerstand RG fliessenden Urstromes $I_{KO}$ über den Widerstand RE3 in der Emitterleitung des Transistors T3 abgeleitet. Durch den Transistor T4 fliesst deshalb ein entsprechend verkleinerter Strom $I_K$. Dies ist der Urstrom des Differenzverstärkers VD1.

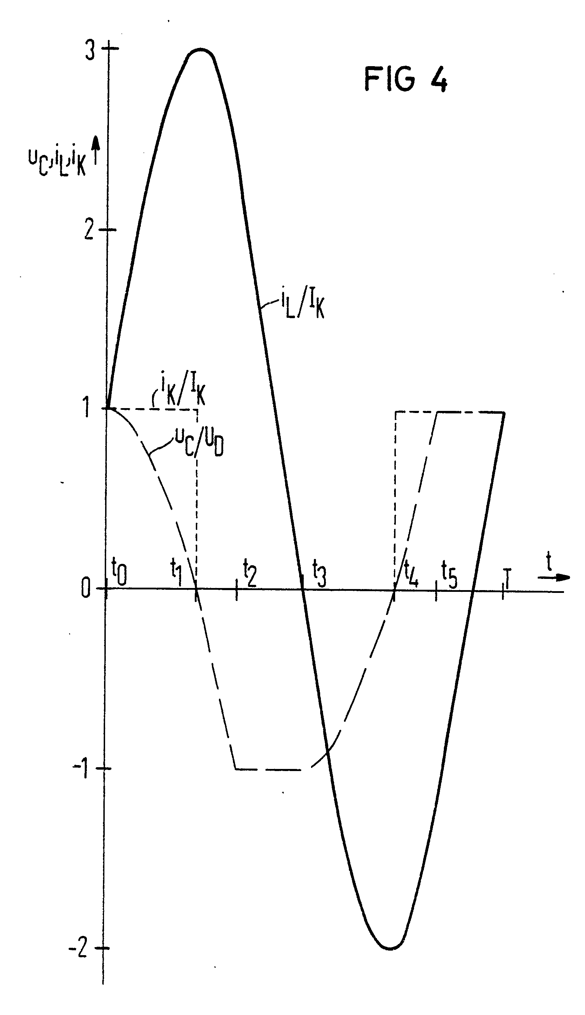

Im Zeitdiagramm Fig. 4 ist eine Periode des Strom- und Spannungsverlaufs im Oszillator-Schwingkreis LC im eingeschwungenen Zustand mit $I_K$ bzw. $U_D$ normiert dargestellt. Durchgezogen gezeichnet ist die Kurve für den durch die Spule fliessenden Strom $i_L$. Der Spannungsverlauf am Schwingkreis $u_C$ ist als unterbrochene Linie dargestellt, und der durch den Transistor T1 fliessende Strom $i_K$ ist als kurz gestrichelte Linie gezeichnet.

Auf der Zeitachse sind die markanten Zeitpunkte mit $t_1$, $t_2$, $t_3$ usw. gekennzeichnet. Der Beginn der dargestellten Periode ist mit $t_0$ bezeichnet, das Ende dieser Periode mit T. Zum Zeitpunkt $t_0$ besteht keine spannungsbegrenzende Wirkung der Dioden D1 und D2 mehr. Der Spannungsverlauf $u_C$ am Schwingkreis ist der einer freien Schwingung mit der Kreisfrequenz $\omega_0 = 1/\sqrt{LC}$. Zum Zeitpunkt $1_1$ wird der Transistor T1 gesperrt, so dass der durch ihn fliessende Strom $i_K$ zu Null wird. Der Spannungsverlauf am Schwingkreis erfolgt auch weiterhin mit der gleichen Kreisfrequenz $\omega_0$, wobei sich jedoch die Amplitude des Spannungsverlaufes, bedingt durch das Abschalten des Stromes $i_K$, geändert hat. Zum Zeitpunkt $t_2$ setzt bei der Spannung $U_D$ die Begrenzerwirkung der Dioden D1, D2 ein. Der durch die Dioden fliessende Strom ist mit $i_D$ bezeichnet. Die Spannung am Schwingkreis kann hierdurch nicht mehr ansteigen. Der durch die Spule fliessende Strom $i_L$ wird weiterhin geringer.

Zum Zeitpunkt $t_3$ ist die spannungsbegrenzende Wirkung der Dioden D1, D2 wieder aufgehoben. Der Spannungsverlauf am Schwingkreis entspricht wieder dem einer freien Schwingung bis zum Zeitpunkt $t_4$. Ab diesem Zeitpunkt ist der Transistor T1 wieder leitend geschaltet. Der Spannungsverlauf am Schwingkreis setzt sich mit der Frequenz einer freien Schwingung fort, jedoch, bedingt durch die Stromänderung $i_K$, mit vergrösserter Amplitude.

Zum Zeitpunkt $t_5$ setzt die spannungsbegrenzende Wirkung der Dioden D1, D2 erneut ein, während der durch die Spule fliessende Strom $i_L$ weiter ansteigt. Zum Zeitpunkt T endet die spannungsbegrenzende Wirkung der Dioden D1, D2, womit eine Schwingungsperiode beendet ist und sich der Spannungsverlauf wiederholt. Die Periodendauer einer Schwingung wurde nahezu um die Zeitintervalle $t_2$ bis $t_3$ und $t_5$ bis T gegenüber einer Periodendauer einer freien Schwingung verlängert.

Durch Vergrösserung des Urstromes $I_K$ des Differenzverstärkers VD1 werden die Zeiträume $T_2$ bis $t_3$ und $t_5$ bis T, in denen eine Begrenzerwirkung der Dioden D1, D2 auftritt, ebenfalls vergrössert. Somit ist die Oszillatorfrequenz vom Urstrom $I_K$ abhängig.

Der Strom- und Spannungsverlauf im Oszillator-Schwingkreis kann rechnerisch ermittelt werden. In den Zeitintervallen $t_0$ bis $t_1$, $t_1$ bis $t_2$, usw. gelten folgende Differentialgleichungen (DG 1.1 bis DG 6.2):

$$t_0 - t_1: \quad DG\ 1.1\ C\ \frac{du_C}{dt} + i_L = I_K, \quad DG\ 1.2\ L\ \frac{di_L}{dt} = u_C$$

$$t_1 - t_2: \quad DG\ 2.1\ C\ \frac{du_C}{dt} + i_L = O, \quad DG\ 2.2\ L\ \frac{di_L}{dt} = u_C$$

$$t_2 - t_3: \quad DG\ 3.1\quad i_D + i_L = O, \quad DG\ 3.2\ L\ \frac{di_L}{dt} = u_D$$

$$t_3 - t_4: \quad DG\ 4.1\ C\ \frac{du_C}{dt} + i_L = O, \quad DG\ 4.2\ L\ \frac{di_L}{dt} = u_C$$

$$t_4 - t_5: \quad DG\ 5.1\ C\ \frac{du_C}{dt} + i_L = I_K, \quad DG\ 5.2\ L\ \frac{di_L}{dt} = u_C$$

$$t_5 - T: \quad DG\ 6.1\ C\quad i_D + i_L = I_K, \quad DG\ 6.2\ L\ \frac{di_L}{dt} = u_D$$

Wenn man die Dioden D1, D2 als ideale Begrenzer ansieht, lässt sich für das Differentialgleichungssystem die Lösung wie folgt ermitteln: Für jedes Intervall innerhalb einer Periode kann eine spezielle Lösung angegeben werden, die am Anfang und am Ende des Intervalls stetig in die speziellen Lösungen der Nachbarintervalle übergeht. Insgesamt bilden alle so erhaltenen Lösungen die Lösung für den Strom- und Spannungsverlauf im eingeschwungenen Zustand. Die graphische Darstellung der Lösung ist in Fig. 4 wiedergegeben.

In den Intervallen $0 \le t \le t_2$ und $t_3 \le t \le t_5$ ergibt sich folgende allgemeine Lösung:

$$u_C(t) = U_{CO} \cos \omega_0(t-t_K)t + (i_K(t) - I_{LO})$$

$$\sqrt{\frac{L}{C}} \sin \omega_0(t-t_x)$$

$$i_L(t) = I_{LO}-i_K(t) \cos \omega_0(t-t_x) + U_{CO}$$

$$\sqrt{\frac{C}{L}} \sin \omega(t-t_x) + i_K(t)$$

hierbei bedeutet:
$U_{CO}, I_{LO}$ = jeweilige Anfangswerte für $u_C$, $i_L$ an den Intervallgrenzen $t_x = t_0, t_1, t_3, t_4$.

Für die Zeitintervalle $t_2 \le t \le t_3$ und $t_5 \le t \le T$ gilt:

$$u_C(t) = U_{CO} = U_D$$

$$i_L(t) = -\frac{U_{CO}}{L}(t-t_x) + I_{LO}$$

hierbei bedeuten:
$U_{CO}, I_{LO}$ = jeweilige Anfangswerte für $u_C$, $i_L$ an den Intervallgrenzen $t_x = t_2, t_5$.

Hiermit ergeben sich die Lösungen GL 1.1 bis GL 6.2 der Differential-Gleichungen DG 1.1 bis DG 6.2:

$0 \le t \le t_1$:

GL 1.1 $u_C(t) = U_D \cos \omega_0 t$

GL 1.2 $i_L(t) = U_D\sqrt{\frac{C}{L}} \sin \omega_0 t + I_K$

$t_1 \le t \le t_2$:

GL 2.1 $u_C(t) = -(I_K\sqrt{\frac{L}{C}} + U_D) \sin \omega_0(t-t_1)$

GL 2.2 $i_L(t) = (I_K + U_D\sqrt{\frac{C}{L}}) \cos \omega_0(t-t_1)$

$t_2 \le t \le t_3$:

GL 3.1 $u_C(t) = -U_D$

GL 3.2 $i_L(t) = -\frac{U_D}{L}(t-t_2) + I_K\sqrt{1 + 2U_D : I_K\sqrt{\frac{L}{C}}}$

$t_3 \le t \le t_4$:

GL 4.1 $u_C(t) = -U_D \cos \omega_0(t-t_3)$

GL 4.2 $i_L(t) = -U_D\sqrt{\frac{C}{L}} \sin \omega_0(t-t_3)$

$t_4 \le t \le t_5$:

GL 5.1 $u_C(t) = (U_D + I_K\sqrt{\frac{L}{C}}) \sin \omega_0(t-t_4)$

GL 5.2 $i_L(t) = -(U_D\sqrt{\frac{C}{L}} + I_K) \cos \omega_0(t-t_4) + I_K$

$t_5 \le t \le T$:

GL 6.1 $u_C(t) = + U_D$

GL 6.2 $i_L(t) = \frac{U_D}{L}(t-t_5) - I_K(\sqrt{1 + 2U_D : I_K\sqrt{\frac{L}{C}}} - 1)$

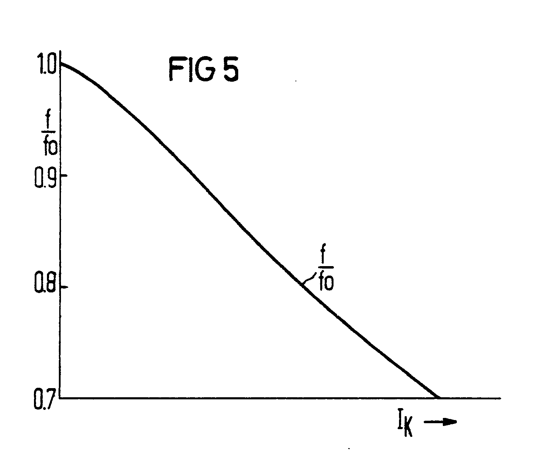

Aufrund dieser Lösungen lässt sich die Periodendauer errechnen und deren Abhängigkeit vom Urstrom $I_K$. Dieser Zusammenhang ist in Fig. 5 graphisch dargestellt.

Ergänzend soll zu der graphischen Darstellung in Fig. 4 noch folgendes gesagt werden: Wenn in einer Oszillatorschaltung ein Strom von der Grösse $\pm I_K$ den Parallelschwingkreis L, C ansteuert, dann ergibt sich ein symmetrischer Verlauf der Ströme und Spannungen am Schwingkreis.

Der in Fig. 6 dargestellte, teilweise integrierbare LC-Oszillator enthält, wie im ersten Ausführungsbeispiel Fig. 2 bereits beschrieben, einen Differenzverstärker VD1 in der Oszillatorschaltung und einen zweiten Differenzverstärker VD2 als steuerbare Konstantstromquelle.

Über einen Anschlusspunkt A11 wird der nicht integrierte Parallel-Schwingkreis L, C an den Kollektor des Transistors T3 des ersten Differenzverstärkers VD1 angeschlossen. Der zweite Schwingkreisanschluss wird mit dem Versorgungspotential +UB verbunden. Die zur Begrenzung der Schwingkreisspannung dienenden Dioden D1 und D2 sind Bestandteil der integrierten Schaltung.

Bei dem als Konstantstromquelle arbeitenden Differenzverstärker VD2 sind die zwischen der Basis des Transistors T4 und dem Masseanschlusspunkt M liegenden Dioden D5 und D6 über den Widerstand RB mit dem Versorgungspotential +UB verbunden.

Die Anpassung der Potentialunterschiede erfolgt über zwei weitere Konstantstromquellen mit nachgeschalteten Emitterfolgern.

Die erste zusätzliche Konstantstromquelle besteht aus einem Transistor T5, dessen Emitter über einen Wiederstand RE5 mit Masse M verbunden ist. Der Kollektor ist über einen Widerstand RC5 an das Versorgungspotential +UB angeschaltet. Ausserdem ist am Kollektor des Transistors T5 die Basis des Emitterfolgers T7 angeschaltet. Der Emitter dieses Transistors ist mit der Basis des Transistors T1 des ersten Differenzverstärkers und über einen Widerstand RE7 mit Masse verbunden; der Kollektor ist mit dem Versorgungspotential +UB verbunden.

Die Basis des als Konstantstromquelle geschalteten Transistors T5 ist mit der Basis des Transistors T4 des zweiten Differenzvertärkes und mit der Basis des Transistors T6, der zweiten zusätzlichen Konstantstromquelle, verbunden.

Der Emitter des Transistors T6 ist über einen Widerstand RE6 mit Masse verbunden, der Kollektor ist über einen Wiederstand RC6 mit dem Anschlusspunkt A11 des Parallel-Schwingkreises L, C verbunden.

An den Kollektor des Transistora T6 ist die Basis eines zweiten Emitterfolgers T8 angeschaltet. Der Emitter des Transistors T8 ist mit der Basis des Transistors T2 des ersten Differenzverstärkers VD1 und über einen Widerstand RE8 mit Masse verbunden; der Kollektor des Transistors T8 ist mit dem Versorgungspotential +UB verbunden.

Die Funktion der Schaltung entspricht der Funktion des ersten Ausführungsbeispiels. Die Rückkopplung der Schwingkreisspannung erfolgt vom Anschlusspunkt A11 des Schwingkreises über den Widerstand RC6 und den Transistor T8 zum zweiten Eingang des ersten Differenzverstärkers VD1, der Basis des Transistors T2. Die Potentialspannung erfolgt durch die von den beiden zusätzlichen Konstantstromquellen erzeugten Konstantströme und die Widerstände RC5 und RC6 in den Kollektorkreisen der Transistoren T5 und T6. Auch in diesem Ausführungsbeispiel werden nur npn-Transistoren verwendet.

Bei monolithischer Teilintegration des Oszillators werden ausser den Versorgungsspannungsanschlüssen nur zwei weitere Anschlusspunkte, davon einer für den Parallel-Schwingkreis und einer für den Steuereingang, benötigt.

In einer dualen Lösung wird statt des Parallel-Schwingkreises ein Serien-Schwingkreis verwendet.

**Patentansprüche**

1. Stromgesteuerter Oszillator mit einem Differenzverstärker (VDI), der zwei emittergekoppelte Transistoren (T1, T2) enthält, deren Emitter an eine steuerbare Urstromquelle angeschaltet sind, und mit einem Parallel-Schwingkreis (L, C), der zwischen dem Kollektor des ersten Transistors (T1) und dem Versorgungspotential (+UB) angeschaltet ist und auf mindestens einen Eingang des Differenzverstärkers (VD1) rückgekoppelt ist, dadurch gekennzeichnet, dass zu dem Parallel-Schwingkreis (L, C) ein spannungsbegrenzendes zusätzliches Bauelement (BU) parallelgeschaltet ist, dass der Kollektor des zweiten Transistors (T2) über einen Widerstand (RC2) an das Versorgungspotential (+UB) angeschlossen ist, dass der Kollektor des zweiten Transistors (T2) den Ausgang (A2) der Oszillatorschaltung bildet und dass als steuerbare Urstromquelle ein zweiter Differenzverstärker (VD2) vorgesehen ist.

2. Oszillator nach Anspruch 1, dadurch gekennzeichnet, dass der zweite Differenzverstärker (VD2) zwei emittergekoppelte Transistoren (T3, T4) enthält, dass der Kollektor des einen Transistors (T4), dessen Basis an einem festen Spannungspotential liegt, mit den Emittern der beiden Transitoren (T1, T2) des Differenzverstärkers (VD1) verbunden ist, dass der Kollektor des anderen Transistors (T3) des weiteren Differenzverstärkers (VD2) mit dem Versorgungspotential (+UB) verbunden ist, dass an der Basis des anderen Transistors (T3) eine frequenzbestimmende Steuerspannung (Uf) anliegt und dass der beiden Emittern der Transistoren (T3, T4) des zweiten Differenzverstärkers (VD2) gemeinsame ohmsche Emitterwiderstand (RG) an Masse (das zweite Versorgungspotential) geschaltet ist (Fig. 2).

3. Oszillator nach einem der vorhergehenden Ansprüche, dadurch gekennzeichnet, dass als spannungsbegrenzendes Bauelement (BU) antiparallelgeschaltete Dioden (D1, D2) vorgesehen sind.

4. Oszillator nach einem der vorhergehenden Ansprüche, dadurch gekennzeichnet, dass eine steuerbare Stromquelle (SI) mit dem gleichen relativen Temperaturverhalten wie das parallel zum Schwingkreis (L, C) geschaltete spannungsbegrenzende Bauelement (BU) vorgesehen ist.

5. Oszillator nach einem der Ansprüche 2 bis 4, dadurch gekennezeichnet, dass die Anpassung der Potentialunterschiede zwischen der Schwingkreisspannung und dem Eingang des ersten Differenzverstärkers (VD1) sowie die Festlegung des Arbeitspunktes des ersten Differenzverstärkers (VD1) durch zwei gleich aufgebaute Konstantstromquellen (T5, T6) mit nachgeschalteten Emitterfolgern (T7, T8) realisiert ist (Fig. 6).

6. Oszillator nach Anspruch 5, dadurch gekennzeichnet, dass der Oszillator in monolithischer Teilintegration ausgeführt ist.

7. Oszillator nach einem der Ansprüche 1 bis 6, dadurch gekennzeichnet, dass in den Rückkopplungsweg ein phasendrehendes Bauelement zur Linearisierung des Frequenzganges des Oszillators eingeschaltet wird.

8. Oszillator nach einem der Ansprüche 1 bis 6, dadurch gekennzeichnet, dass das phasendrehende Bauelement im Rückkopplungsweg derart dimensioniert ist, dass der Frequenzgang des Oszillators in Abhängigkeit vom Steuerstrom ($I_K$) ein flaches Maximum aufweist.

**Claims**

1. A current controlled oscillator with a differential amplifier (VD1) which contains two emitter-coupled transistors (T1, T2) whose emitters are connected to a controllable current source, and with a parallel oscillatory circuit (L, C) connected between the collector of the first transistor (T1) and the supply potential (+UB) and fed-back to at least one input of the differential amplifier (VD1), characterised in that a voltage-limiting additional component (BU) is connected across the parallel oscillatory circuit (L, C), that the collector of the second transistor (T2) is connected via a resistor (RC 2) to the supply potential (+UB), that the collector of the second transistor (T2) forms the oscillator output (A2), and that a second differential amplifier (VD2) is provided as the controllable current source.

2. An oscillator as claimed in Claim 1, characterised in that the second differential amplifier (VD2) contains two emitter-coupled transistors (T3, T4), that the collector of the first transistor (T4) is connected to the emitters of the two transistors (T1, T2) of the differential amplifier (VD1) and its base is connected to a point of fixed potential, that the collector of the other transistor (T3) of the further differential amplifier (VD2) is connected to the supply potential (+UB), that a frequency-determining control voltage (Uf) is connected to the base of the other transistor (T3), and that the ohmic emitter-resistor (RG) common to the two emitters of the transistors (T3, T4) of the second differential amplifier (VD2) is connected to earth (the second supply potential). (Fig. 2).

3. An oscillator as claimed in one of the preceding claims, characterised in that antiparallel-connected diodes (D1, D2) are provided as the voltage-limiting component (BU).

4. An oscillator as claimed in one of the preceding Claims, characterised in that a controllable current source (SI) is provided which possesses the same relative temperature characteristic as the voltage-limiting component (BU) which is connected in parallel to the oscillating circuit (L, C).

5. An oscillator as claimed in one of the Claims 2 to 4, characterised in that the matching of the potential differences between the oscillatory circuit voltage and the input of the first differential amplifier (VD1) and the determining of the operating point of the first differential amplifier (VD1) is effected by means of two constant current sources (T5, T6) of identical construction connected at their output end to emitter followers (T7, T8). (Fig. 6).

6. An oscillator as claimed in Claim 5, characterised in that the oscillator is constructed as a subsidiary monolythic integration.

7. An oscillator as claimed in one of the Claims 1 to 6, characterised in that a phase-rotating component which serves to linearise the frequency response of the oscillator is connected into the feedback path.

8. An oscillator as claimed in one of the Claims 1 to 6, characterised in that the dimensions of the phase-rotating component in the feedback path are such that the frequency response of the oscillator exhibits a flat maximum in dependence upon the control current ($I_K$).


**Revendications**

1. Oscillateur commandé en courant comportant un amplificateur différentiel (VD1) qui comprend deux transistors (T1, T2) à émetteurs couplés, dont les émetteurs sont reliés à une source de courant primaire commandable, ainsi qu'un circuit oscillant parallèle (L, C) qui est monté entre le collecteur du premier transistor (T1) et le potentiel d'alimentation (+UB) et qui est ramené sur au moins une entrée de l'amplificateur différentiel (VD1), caractérisé par le fait qu'un élément supplémentaire (BU) de limitation de tension est monté en parallèle sur le circuit oscillant parallèle (L, C), que le collecteur du second transistor (T2) est relié au potentiel d'alimentation (+UB) par l'intermédiaire d'une résistance (RC2), que le collecteur du second transistor (T2) forme la sortie (A2) du circuit d'oscillateur, et qu'il est prévu un second amplificateur différentiel (VD2) en tant que source de courant primaire commandable.

2. Oscillateur suivant la revendication 1, caractérisé par le fait que le second amplificateur différentiel (VD2) comporte deux transistors (T3, T4) à émetteurs couplés, que le collecteur d'un des transistors (T4), dont la base est reliée à un potentiel de tension fixe, est relié aux émetteurs des deux transistors (T1, T2) de l'amplificateur différentiel (VD1), que le collecteur de l'autre transistor (T3) de l'autre amplificateur différentiel (VD2) est relié au potentiel d'alimentation (+UB), qu'une tension de commande (Uf) qui détermine la fréquence est appliquée à la base de l'autre transistor (T3), et qu'aux deux émetteurs des transistors (T3, T4) du second amplificateur différentiel (VD2) est reliée une résistance ohmique d'émetteur commune (RG) à la masse (le second potentiel d'alimentation) (figure 2).

3. Oscillateur suivant l'une des revendications précédentes, caractérisé par le fait que des diodes (D1, D2) montées en antiparallèle sont prévues en tant qu'élément de limitation de tension (BU).

4. Oscillateur suivant l'une des revendications précédentes, caractérisé par le fait qu'il est prévu une source de courant commandable (SI) qui présente le même comportement relatif en température que l'élément de limitation de tension (BU) qui est monté en parallèle sur le circuit oscillant (L, C).

5. Oscillateur suivant l'une des revendications 2 à 4, caractérisé par le fait que l'adapatation des différences de potentiel entre la tension du circuit oscillant et l'entrée du premier amplificateur différentiel (VD1) ainsi que la détermination du point de travail du premier amplificateur différentiel (VD1) sont réalisées par deux sources de courant constant de constitution identique (T5, T6) comportant des émetteurs suiveurs montés en aval (T7, T8) (figure 6).

6. Oscillateur suivant la revendication 5, caractérisé par le fait que l'oscillateur est réalisé par intégration partielle monolithique.

7. Oscillateur suivant l'une des revendications 1 à 6, caractérisé par le fait qu'un élément de déphasage est monté dans la branche de contre-réaction pour linéariser l'allure de fréquence de l'oscillateur.

8. Oscillateur suivant l'une des revendications 1 à 6, caractérisé par le fait que l'élément déphaseur dans la branche de contre-réaction est dimensionné de manière que l'allure de fréquence de l'oscillateur présente un maximum plat en fonction du courant de commande ($I_K$).

# FIG 1

# FIG 2

# FIG 3

FIG 4

FIG 5

# FIG 6